# EUROPEAN PATENT SPECIFICATION

(11) **EP 2 758 996 B1**
(45) Date of publication and mention of the grant of the patent: **01.04.2020**
(21) Application number: 12832908.3
(22) Date of filing: 21.09.2012
(51) Int. Cl.: H01L 31/0352, H01L 31/0735, H01L 31/0304

(54) **VARYING BANDGAP SOLAR CELL**
SOLARZELLE MIT VARIABLER BANDLÜCKE
CELLULE SOLAIRE À BANDE INTERDITE VARIABLE

(30) Priority: 23.09.2011 AU 2011903944
(43) Date of publication of application: 30.07.2014
(73) Proprietor: Gallium Enterprises Pty Ltd, Silverwater, NSW 2128 (AU)
(72) Inventor: BARIK, Satyanarayan, Holroyd, New South Wales 2142 (AU)
(74) Representative: Wilson Gunn
(86) International application number: PCT/AU2012/001152
(87) International publication number: WO 2013/040659

(56) References cited:
- WO-A1-2011/016537
- WO-A2-01/47031
- CN-A- 102 103 990
- GB-A- 2 463 905
- JP-A- H11 220 150
- US-A- 4 688 068
- US-A- 6 147 296
- US-A1- 2004 135 222
- US-B1- 6 437 233
- BARNHAM, K.: 'A new approach to high-efficiency multi-band-gap solar cells' JOURNAL OF APPLIED PHYSICS vol. 67, no. 7, 1990, pages 3490 - 3493, XP000115622

## Description

### FIELD OF THE INVENTION

The present invention relates to a solar cell and, particularly, to a solar cell design incorporating multiple quantum wells.

### BACKGROUND OF THE INVENTION

Semiconductor solar cells, such as indium gallium nitride (InGaN) cells, have the potential to improve the efficiency of existing solar capture technology. InGaN, in particular, shows great promise as a solar cell semiconductor material due to its tuneable direct bandgap which can vary from about 0.67eV to about 3.4 eV as the indium content in the In*ₓ*Ga*₁₋ₓ*N layer changes from 0.0 to 1.0 and thereby demonstrates absorption across almost the entire solar spectrum. InGaN possesses further useful properties such as a high carrier mobility, high saturation velocity and reasonable resistance to high temperatures and radiation.

Typically, in forming such solar cells, GaN layers will be employed as the base or underlying epitaxial layer on which relatively high indium content InGaN layers are grown to enable the desired absorption efficiency to be achieved. One problem with this approach is the high strain which develops due to the large lattice mismatch between In*ₓ*Ga*₁₋ₓ*N and GaN which can lead to undesirable consequences such as phase separation and misfit dislocations. This makes the growth of relatively thick InGaN layers, which would be useful for increasing absorption of solar energy, a difficult approach in practice.

One solution which has been proposed is the use of multiple quantum wells (MQW) within the structure. Each quantum well (QW) is a very thin layer of semiconductor material which demonstrates a low bandgap and is sandwiched between two barrier layers of higher bandgap. The use of multiple quantum wells is a viable approach when dealing with semiconductor materials, such as InGaN, which have high optical absorption coefficients and therefore very thin layers of the material may provide a sufficient level of absorption.

The use of these low dimensional multiple quantum wells of, for example, InGaN, enables high quality crystalline layers to be formed by comparison to thicker InGaN layers and so interlayer strain and phase separation are greatly reduced while providing the further benefit of quantized energy levels.

However, to date, prior art examples of the use of multiple quantum wells in solar cells have suffered from less than optimal light absorption as well as significant polarization-related charges thereby resulting in relatively low energy conversion of sunlight to electrical energy.

U.S. patent publication no. 2011/0220190 proposes the use of a graded buffer layer in a solar cell, which can comprise InGaAs, GaAs, AlGaAs, InGaP, AlGaInP and AlGaInAs. These materials are used for group III-V (multi-junction) solar cells, in which the group V elements are As and/or P.

U.S. patent publication no. 2011/0197956 describes the use of layers comprising an amorphous SiGe layer, or a mixed layer of a-Si and µc-Si, or a mixed layer of a-Si and poly-Si as a transition layer or a tunnelling junction between a large bandgap light absorption layer, such as a-Si, and a small bandgap light absorption layer, such as c-Si. It contemplates that the transition layer may have a gradually varying bandgap achieved, for example, by continuously changing the hydrogen content in a process gas during film formation to thereby change the crystallinity of the Si layer. For example, a layer with a-Si (crystallinity=0%) gradually varied into µc-Si (crystallinity=60 to 100%).

US2009/0255580 describes the use of quantum dots of different size in quantum dot solar cells. Quantum dot solar cells and quantum well solar cells are treated separately in the industry due to the differing structure meaning the drawing of comparisons is unreliable. Thus, for non-quantum dot solar cells this document offers little assistance.

WO 2000/077861 describes a device comprising a number of different wavelength-selective active layers arranged in a vertical stack with monotonically decreasing bandgaps. Within each layer, the bandgap remains the same, while in the subsequent layer underneath the bandgap decreases. The contacts are made separately on the lateral sides of each layer. The document mentions the use of these thin film layer structures for possible solar cell applications but with the primary emphasis on imagery applications. It mentions that the use of quantum wells with ultra-wide bandgap semiconductors or insulators would not enable the necessary ohmic contacts across the layers in the stack. This document therefore does not provide a satisfactory solution to the problems discussed above.

There is a need for a solar cell which can harness the advantages of multiple quantum wells while improving light absorption and therefore overall efficiency.

### SUMMARY OF THE INVENTION

Described herein is a solar cell comprising a multiple quantum well active region wherein the composition of each quantum well layer differs from that of neighbouring or consecutive quantum well layers.

In a first aspect, the invention resides in a solar cell comprising:
(a) a first junction layer;
(b) a second junction layer; and
(c) an active region between the first and second junction layers, the active region comprising a plurality of quantum well layers each of which is sandwiched between barrier layers and the material forming each quantum well layer is independently a group III nitride,
wherein, consecutive quantum well layers have different bandgap values due to variations in the thickness of the layers and/or their having differing compositions of at least one of their constituent elements, and wherein each quantum well layer is less than 7nm thick.

Preferably, the bandgap of consecutive quantum well layers decreases on moving away from a surface of the solar cell upon which, in use, sunlight will be incident.

The group III element may be selected from the group consisting of boron, aluminium, gallium and indium.

The adjacent quantum well layers may present differing quantized energy levels.

Preferably, the content of at least one group III element in consecutive quantum well layers increases on moving further away from an extent of the solar cell upon which, in use, sunlight is incident.

It will be appreciated that while the content of one group III element in consecutive quantum well layers increases on moving further away from an extent of the solar cell upon which, in use, sunlight is incident, another group III element content may decrease. For example, if the quantum well layers were comprised of InGaN then the indium content may increase and the gallium content decrease on moving further away from an extent of the solar cell upon which, in use, sunlight is incident. Thus the overall balance of group III elements is maintained.

Alternatively or in combination, the thickness of consecutive quantum well layers decreases on moving further away from an extent of the solar cell upon which, in use, sunlight is incident.

In one embodiment, the composition of individual quantum well layers is substantially constant throughout their extent.

In an alternative embodiment, the composition of individual quantum well layers may vary in a continuous fashion on proceeding through the quantum well layer from a region contacting one adjacent barrier layer to a region contacting the other adjacent barrier layer.

There may be overlap between the elemental composition of portions of consecutive quantum well layers but it will be understood that the general trend is that the relative content of the at least one constituent element will increase, and the relative content of an associated or companion element will decrease, in consecutive quantum well layers on moving away from that quantum well layer closest, in use, to the incident sunlight in such a way that the band gaps of the quantum well layers decrease as they move further away from the sun facing layer.

Suitably, the quantum well layers comprise two or more constituent elements and it is the relative content of at least two of these elements which changes between different layers.

Preferably, the at least one constituent element which is differing in content between quantum well layers is a group III element selected from the group consisting of indium, aluminium and gallium.

More preferably, the group III element which is differing in content between quantum well layers is indium.

More preferably, the material forming the quantum well layers is selected from the group consisting of indium gallium nitride, aluminium indium gallium nitride, indium aluminium nitride, aluminium gallium nitride,, indium gallium arsenide nitride and aluminium indium gallium arsenide nitride indium gallium phosphide. , Even more preferably, the material forming the quantum well layers is indium gallium nitride.

In a preferred embodiment wherein the quantum well layers are formed from indium gallium nitride, the quantum well layer having the highest bandgap and being located at the end of the solar cell closest to the surface adapted to receive sunlight will be the quantum well layer with the lowest indium content.

Preferably, each quantum well layer is between 1 to 5 nm thick, more preferably about 3 nm thick.

The barrier layers may be formed from the same or different materials to the quantum well layers.

Preferably, the barrier layers comprise material selected from the group consisting of gallium nitride, aluminium nitride, indium gallium nitride, indium aluminium nitride and aluminium indium gallium nitride such that the bandgaps of the barrier layers are higher than the bandgap of the sandwiched quantum well layer.

In one embodiment the solar cell further comprises one or more blocking layers.

Preferably, the one or more blocking layers will have a higher bandgap than the quantum well or barrier layers.

Suitably, for a *p-i-n* InGaN/GaN solar cell a *p*-AlGaN layer is present before the *p*-GaN layer and an *n*-AlGaN layer after the *n*-GaN layer.

Preferably, the solar cell is grown on a substrate selected from the group consisting of sapphire, zinc, glass and other silicon based substrates. Patterned sapphire substrates are particularly preferred.

In a second aspect the invention resides in a method of forming a solar cell comprising a multiple quantum well structure, the method including the steps of:
(a) forming a barrier layer;
(b) forming a desired thickness of a quantum well layer from a group III nitride on top of the barrier layer;
(c) forming a further barrier layer on top of the exposed quantum well layer such that the quantum well layer is sandwiched between the two barrier layers;
(d) forming a desired thickness of a further quantum well layer from a group III nitride on top of the exposed further barrier layer; and
(e) repeating steps (c) to (d) to form a desired number of quantum wells wherein consecutive quantum well layers have different bandgap values due to variations in the thickness of the layers and/or their having differing contents of the at least one group III nitride, and wherein each quantum well layer is less than 7 nm thick
to thereby form a solar cell comprising a multiple quantum well structure.

In one preferred embodiment, the content of the at least one group III element in consecutive quantum well layers increases on moving further away from an extent of the solar cell upon which, in use, sunlight is incident.

In one embodiment, the at least one group III element content within individual quantum well layers is substantially constant.

In an alternative embodiment, the at least one group III element content within individual quantum well layers may vary in a continuous fashion on proceeding through the quantum well layer from a region contacting one adjacent barrier layer to a region contacting the other adjacent barrier layer.

The method may further include the step of forming a junction layer on a substrate and subsequently forming the first barrier layer or quantum well layer upon the junction layer.

The method may further include the step of forming a further junction layer on top of the final quantum well layer to be formed.

In an alternative embodiment, the method may include the step of forming the multiple quantum well structure such that the content of the at least one group III element in consecutive quantum well layers decreases on moving further away from an extent of the solar cell upon which, in use, sunlight is incident.

In this alternative embodiment, the method may further include the step of separating the multiple quantum well structure from an underlying substrate and reversing the structure such that the content of the at least one group III element in consecutive quantum well layers increases on moving further away from an extent of the solar cell upon which, in use, sunlight is incident.

The solar cell of this alternative embodiment may be formed on a transparent substrate.

Further features of the present invention will become apparent from the following detailed description.

Throughout this specification, unless the context requires otherwise, the words "comprise", "comprises" and "comprising" will be understood to imply the inclusion of a stated integer or group of integers but not the exclusion of any other integer or group of integers.

### BRIEF DESCRIPTION OF THE FIGURES

In order that the invention may be readily understood and put into practical effect, preferred embodiments will now be described by way of example with reference to the accompanying figures wherein:
FIG 1 shows a schematic representation of a first embodiment of a multiple quantum well solar cell;
FIG 2 shows a schematic representation of a second embodiment of a multiple quantum well solar cell;
FIG 3 shows a diagrammatic representation of experimentally obtained I-V characteristics of the multiple quantum well solar cell of FIG 1;
FIG 4 shows a diagrammatic representation of experimentally obtained characteristics I-V of two multiple quantum well solar cells; and
FIG 5 shows a diagrammatic representation of experimentally obtained external quantum efficiency and internal quantum efficiency characteristics of the multiple quantum well solar cells of FIG 4.

### DETAILED DESCRIPTION OF THE INVENTION

This invention is predicated on the finding that an improved multiple quantum well solar cell can be achieved by ensuring the bandgap of each quantum well thin layer is not uniform compared with other such layers. It has been found that a gradation of the bandgap by varying the content of at least one, and typically at least two, group III elements, such as the indium and gallium relative contents within InGaN, within consecutively formed quantum wells provides advantages in at least an increase in absorption across a greater range of the available solar spectrum. The same advantages may be obtained by instead, or in combination, varying the thickness of consecutive quantum well layers.

The semiconductor materials which may be employed with the present solar cells, and hence the nature of the layers which can be formed, are not especially limited. Although the embodiments discussed herein generally employ InGaN as the QW material and GaN for the barrier and *p-*and *n*-junction layers, the utility of the present invention is not so limited.

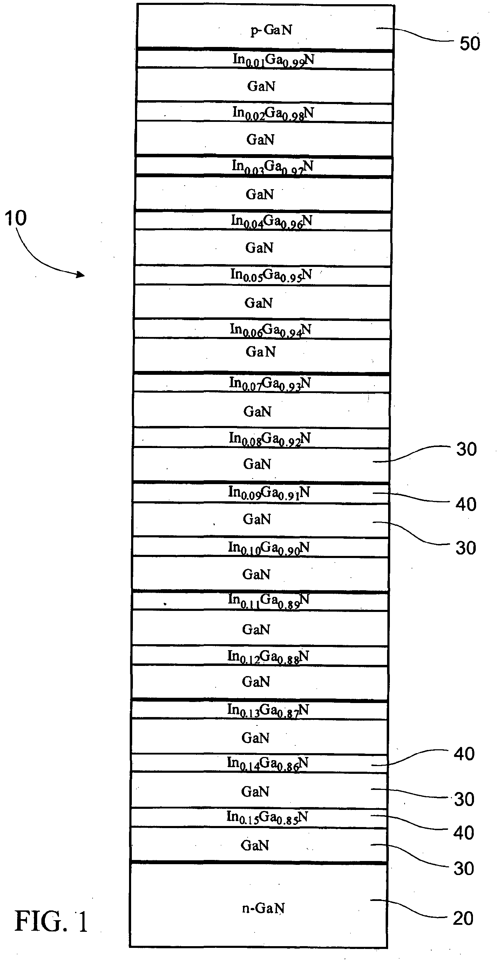

FIG 1 shows a schematic representation of a first embodiment of an MQW solar cell (PV A). FIG 1 is equivalent to the structure represented in Table 1 which provides further detail on the individual layers. Solar cell 10 is generally seen to comprise a *p-i-n* junction structure with a first junction layer 20 being an *n*-GaN layer with a thickness of about 1000 nm and a dopant concentration of 1e19 per cm³. An active region is present located on the first junction layer 20 and is comprised of alternating barrier layers 30 and QW layers 40. Each QW layer 40 is, therefore, sandwiched between two barrier layers 30 to form a quantum well.

In the embodiment shown, a *i*-InGaN semiconductor material forms the QW layers 40 and it will be noted that the composition of each layer 40 is different from that of an adjacent layer 40. A second junction layer 50 is a *p-*GaN layer and results in the active region being located between the first junction layer 20 and the second junction layer 50. Table 1 indicates that the *p*-GaN layer is approximately 150 nm thick with a doping concentration of 1e18 per cm³.

In the embodiment represented by FIG 1 and Table 1, the solar cell 10 is designed such that an end comprising the second junction layer 50 will be exposed to the sun. In going from the first junction layer 20 to the second junction layer 50 it can be seen that the indium content of each consecutive QW layer 40 decreases in a step-wise fashion from a maximum of In_{0.15}Ga_{0.85}N, in layer number 3 of Table 1, (15% indium content) to a minimum of In_{0.01}Ga_{0.99}N in layer number 31 of Table 1 (1% indium content). Thus, the indium content within each individual QW layer 40 is substantially constant but varies from one layer 40 to another.

The thickness of each quantum well layer is less than 7 nm thick.

Preferably, each quantum well layer is between 1 to 5 nm thick, more preferably about 3 nm thick.

Although not shown in FIG 1, the solar cell 10 will be grown on a suitable substrate, such as sapphire. Further standard components may also be present, such as *p*- and *n*-contacts, antireflection layers on the sun-facing side, light reflectors at the back side, tunnelling layers, etc, which are not shown in FIG 1 but which may be necessary for the working of the solar cell 10 and which would be apparent to a skilled addressee.

It is preferred that the QW layer 40 closest to the incoming sunlight, in the case of Table 1 this is layer number 31, should have a higher bandgap and therefore lower indium content than successive QW layers 40. The indium content of the QW layer closest to the incoming sunlight may be between 0% to 100%, preferably between 0.5% and 50%, more preferably between 1% to 40%. Successive QW layers may have an indium content which increases incrementally from this value up to a desired maximum.

The QW layers 40 may be formed from any suitable semiconductor material comprising two or more group III elements. Preferably, at least one of the group III elements is selected from the group consisting of indium, aluminium and gallium..

The material forming the QW layers 40 is preferably a group III nitride, or group III arsenide nitride.

Preferably, the material forming the QW layers 40 is selected from the group consisting of indium gallium nitride, aluminium indium gallium nitride, indium aluminium nitride, aluminium gallium nitride,, indium gallium arsenide nitride and aluminium indium gallium arsenide nitride indium gallium phosphide, .

More preferably, the material forming the quantum well layers is indium gallium nitride. A discussed above, InGaN shows great promise as a solar cell semiconductor material due to its tuneable direct bandgap and absorption across almost the entire solar spectrum as well as demonstrating further useful properties such as a high carrier mobility, high saturation velocity and reasonable resistance to high temperatures and radiation.

Differing embodiments of the MQW solar cell structures may present a wide range in the actual number of quantum wells present. Any number of individual quantum wells between 2 to about 150 may be appropriate so long as the resulting structure is capable of appropriate absorption of sunlight. Preferably, between about 5 to about 100 quantum well layers may be present in the solar cell, more preferably, between about 5 to about 80.

Each barrier layer 30 may be formed from the same or different materials as the QW layers 40. For example, the barrier layers 30 may be formed from gallium nitride, aluminium nitride, indium gallium nitride, indium aluminium nitride or aluminium indium gallium nitride so that the bandgaps of the barrier layers are higher than the bandgap of the sandwiched quantum well layer. Preferably, the barrier layers are gallium nitride layers.

The barrier layers 30 may be between 3 nm to 100 nm thick, preferably between 7 nm to 50 nm thick, more preferably between 10 nm to 30 nm thick and yet more preferably between 10 to 20 nm thick.

The barrier layers 30 should have a higher bandgap than the QW layer 40 which is sandwiched in between them. This may be achieved by the choice of material and/or thickness of the barrier layers 30. Otherwise the nature of the barrier layers 30 is not particularly restricted.

Although, the embodiment of FIG 1, is, as discussed, a *p-i-n* structure, i.e. the sun facing end of the solar cell is a *p*-layer and an *n*-layer is adjacent the substrate end, it is also considered within the scope of the present invention to provide for *n-i-p* solar cells, in which the sun facing side of the solar cell is an *n*-layer and the *p*-layer is adjacent the substrate end. The thickness of the *n*- and *p*-layers may be chosen based on the order of their growth and will preferably range between about 2500 nm and 30 nm, preferably between about 1000 nm and 50 nm. Typically, the sun facing *n*- or *p*-layer is the thinner of the two. The *n* and *p* layers may be doped highly to assist in minimising polarization effects. The doping level of the QW layers 40, i.e. the *i*-layer or intrinsic layer as set out in Table 1, should be kept relatively low.

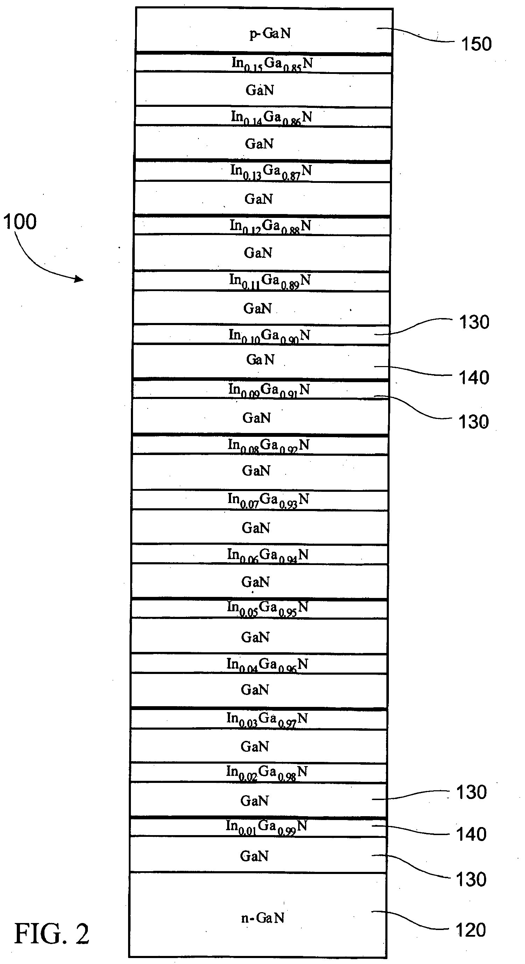

FIG 2 shows a schematic representation of a second embodiment of a multiple quantum well solar cell. As was seen for FIG 1, the solar cell 100 comprises an active region of MQWs sandwiched between a first junction layer 120 of *n*-GaN and a second junction layer 150 of *p*-GaN. The active region MQWs are made up of barrier layers 130 sandwiching QW layers 140. It will be appreciated that the only difference between the embodiment shown in FIG 2 and that of FIG 1 is that the effective order of the QW layers 140, in terms of their indium content, has been reversed. That is, the lowest indium content layer of 1% indium is situated closest to the *n*-GaN first junction layer 120 and therefore furthest away from the incident sunlight. The indium content of each successive or consecutive QW layer 140 increases in a step-wise fashion from that value up to 15% in the QW layer 140 closest to the sun-facing surface of the solar cell 100. Otherwise, all comments made in relation to the embodiment shown in FIG 1, such as the nature of the materials and placement of *n*- and *p*- layers etc., are equally applicable to the embodiment shown in FIG 2.

The advantage offered by the design of FIG 2 is in the quality of the quantum layers 140 which can be grown. InGaN can be degraded at high temperatures and so in the embodiment shown in FIG 1, wherein the highest indium content layers are grown first, relatively low temperatures must be used. When successive QW layers 40 are grown with lower indium content these layers *per se* would be able to withstand higher growth temperatures but the already formed high indium content layers would be degraded and so all remaining QW layers 40 are limited in the temperature at which they can be grown by the first grown, highest indium content layer. InGaN layers with higher indium contents will have a relatively higher lattice mismatch with adjacent GaN layers than those with low indium content and so the platform provided for the building of successive QW 40 and barrier layers 30 is less than optimal.

This problem can be avoided by growing the various layers of the solar cell 100 in the order indicated by FIG 2. The lowest indium content layers are grown first which means they can be grown at higher temperatures which produces an InGaN QW layer 140 of improved quality having better device properties. As successive QW layers 140 are formed the growth temperature can be progressively lowered to suit the particular indium content of the forming layer which means each QW layer 140 is able to be grown at the optimal temperature to thereby provide a structure with lower lattice mismatch, and hence strain, and improved device properties.

As was mentioned in relation to FIG 1, it is preferred that the QW layer 140 of highest bandgap, i.e. lowest indium content, should be the closest to the surface upon which the sun's rays are incident. In the case of the solar cell 100 a transparent substrate may be employed and the cell 100 oriented such that the substrate is close to the incident sunlight to allow this to happen. Alternatively, the first junction layer 120, and hence the MQWs and second junction layer 150 grown on top thereof, can be separated from the substrate and the structure essentially turned upside down so that the lowest indium content layer becomes the closest QW layer 140 to the sun. As discussed for FIG 1, the location of the *n*-GaN and *p*-GaN may be swapped and so both *p-i-n* and *n-i-p* structures are considered. Thus, the embodiment shown in FIG 2 may merely represent the as-grown structure having optimal strain and device characteristics but it will then be oriented, in use, so as to more closely resemble the configuration of FIG 1.

In an alternative embodiment to those shown in FIGs 1 and 2 and exemplified in Table 1, the group III element content, for example the relative indium and gallium content, within each individual QW layer 40 and 140 may vary in a continuous fashion on proceeding from the region contacting one adjacent, upper, barrier layer 30 or 130 to the region contacting the other, lower, adjacent barrier layer 30 or 130.

For example, the lowest indium content QW layer 40 of FIG 1 may have a composition in the region immediately adjacent second junction layer 50 of In_{0.01}Ga_{0.99}N but the indium content of this layer gradually increases until in the region closest to the adjacent barrier layer 30 the composition is more like In_{0.02}Ga_{0.98}N.

There may be overlap between the group III element content of portions of consecutive QW layers 40 but it will be understood that the general trend is that the overall content of the group III element will increase in consecutive quantum well layers, in the manner shown in FIG 1. For example, the QW layer 40 discussed immediately above (closest to second junction layer 50) may have a changing indium content such that it proceeds from In_{0.00}Ga_{1.00}N to In_{0.02}Ga_{0.98}N and the subsequent QW layer 40 has an indium content starting at In_{0.01}Ga_{0.99}N and changing to about In_{0.03}Ga_{0.97}N at its lower extent. Thus the trend of subsequent QW layers 40 towards higher indium contents is maintained even when some overlap between layers is apparent.

This embodiment comprising graded QW layers will provide a solar cell with a useful range of absorption due to the variation in relative indium and gallium content achieved across the MQWs. The nature of the individual layers and the ability to swap junction layers etc is just as applicable to this embodiment as to those discussed in relation to FIGs 1 and 2.

The variation in the bandgap of the individual quantum well layers, which is key to the present invention, may alternatively be achieved by forming consecutive quantum well layers of the same composition and varying the thickness of those layers. This can be achieved by control of growth conditions and times.

The variation in the bandgap of the individual quantum well layers may also be achieved by varying the composition as well as the thickness of consecutive quantum well layers.

Other variations within the embodiments discussed herein may be achieved. For example, the group III element content within the barrier layers 30 or 130 does not necessarily need to remain constant throughout the solar cell 10 or 100. Thus, the barrier layers 30 and 130 of FIGs 1 and 2 may have some indium content and this may vary in association with the gallium content from one barrier layer to the next much in the manner that has been described for the QW layers 40 and 140.

In one embodiment, the indium content within each individual barrier layer 30 and 130 is constant but will increase, and hence the gallium relative content decrease, in a stepwise manner in subsequent barrier layers 30 and 130 on moving further away from the incident sunlight surface. The barrier layer 30 or 130 having the lowest indium content should be closest to the incident sunlight surface and overall their bandgaps should be higher than those of quantum well layers.

In an alternative embodiment, the indium content within each barrier layer 30 or 130 may vary across its extent in exactly the manner described for individual QW layers 40 and 140. The variation will likely be across a small range of about 0.5 to 2.0% and subsequent barrier layers 30 or 130 may demonstrate an overlap in indium content but the overall trend will be towards higher relative indium contents on moving to barrier layers 30 and 130 further from the sunlit surface. A variation in relative indium content across the barrier layers 30 or 130 may assist with improved absorption characteristics of the solar cell 10 or 100 and may aid in reducing problematic polarisation issues.

The only limitation in the variation of the relative indium content within barrier layers 30 and 130, both in a stepwise and a graded fashion, is that the bandgap of any barrier layer 30 or 130 should be higher than that of any of the QW layers 40 or 140. Thus, if the relative indium content of the QW layers 40 or 140 is varied from a minimum of 15% to a maximum of 30% then the relative indium content of the barrier layers 30 or 130 can only be varied from 0 to 14.99%.

In a further embodiment, the first and second junction layers, i.e. the p- and *n*-layers which in FIGs 1 and 2 are doped GaN, may be formed of InGaN and the relative indium content both between the two and within each layer may be varied as discussed above in relation to the QW and/or barrier layers. The main limitation on this is that the junction layer closest to the sunlit surface, which could be a *p*- or *n*-layer, should have a higher bandgap than the subsequent QW or barrier layers. An indium content in the junction layers may help to reduce polarisation problems.

In yet a further embodiment, the solar cell structures described in any of the above embodiments may include some strain balancing QW layers, which will aid in reducing at least a portion of the accumulated strain in the structure. For example, the InGaN/GaN MQW solar cell structures may contain some AIGaN or AIN thin layers, which can present an opposite strain compared to that resulting from InGaN when grown on GaN. These AIGaN or AIN thin layers will therefore help decrease the overall strain of the structure and may improve the performance of the solar cells. The structures may also comprise other types of strain balancing thin or QW layers.

In one preferred embodiment, the solar cell structure may further comprise one or more blocking layers. The blocking layers may be formed before or after the junction layers.

Preferably, the blocking layers will have bandgaps higher than the QW layers and barrier layers and should be capable of reducing or blocking the flow of opposite/undesirable carriers to the p- or n-contacts. For example, one blocking layer may block or reduce the flow of electrons to a p-contact of a solar cell and another blocking layer may block or reduce the flow of holes to an n-contact of a solar cell.

The blocking layers may be made from AIGaN, InAIGaN, AIN and other similar materials which may optionally be suitably doped.

Suitably, for a *p-i-n* InGaN/GaN solar cell a *p*-AlGaN layer is present before the *p*-GaN layer, which blocks or reduces the flow of electrons to the *p*-GaN layer and an *n*-AlGaN layer which blocks or reduces the flow of holes to the n-GaN layer is present after the n-GaN layer.

It has been found that blocking layers can improve the efficiency of a solar cell, as is demonstrated in the results described herein. In an ideal solar cell, only holes will flow to a *p*-contact and electrons will flow to an *n-*contact. However, the reality is that some electrons will inevitably flow to the *p*-contact and some holes will flow to the *n*-contact which results in a loss of solar cell efficiency. The present inventor has found that, in a *p-i-n* InGaN/GaN based solar cell such as that described in FIGs 1 and 2, if a *p-*AlGaN layer is grown before the *p*-GaN layer and an *n*-AlGaN layer grown after the *n*-GaN layer, the above mentioned phenomena can be greatly reduced and the cell efficiency correspondingly improved. AlGaN/GaN QW layers were grown and incorporated into a solar cell structure to form a modified structure (PV B) in which the indium content in the QW layers was varied from 15-20 %. This structure is shown in Table 2.

It has also been realized that, as the indium content within InGaN QW layers increases, the overall strain in the structure increases and hence the quality of the grown layers deteriorates leading to reduced efficiency of the solar cell. To mitigate this problem, in a further preferred embodiment, the present solar cells may be grown on a patterned sapphire substrate (PSS) instead of plain sapphire substrate, which were used in the generation of solar cells PV A and PV B. A new structure (PV C) containing exactly the same order and content of layers as in PV B (as described above) was grown on a PSS. The structure is represented in Table 3. It will be understood that the number of layers (N) shown in Tables 2 and 3 is not considered limiting and is simply by way of example. The number of layers in a cell may be more or less depending on a number of factors including manufacturing concerns, specific application etc. This would be understood by the skilled addressee who could ascertain, without undue experimentation, the preferred number of layers.

The substrate on which the solar cell structures are grown may be chosen from a range of available substrates including glass, silicon and sapphire all of which may be modified or un-modified. Modified substrates may be doped appropriately. A patterned sapphire substrate is particularly preferred.

Both structures PV B and PV C showed photovoltaic effects indicating that varying band gap solar cells are viable options to achieve high energy conversion efficiency and address or mitigate some of the issues that currently plague InGaN/GaN solar cells.

Thus, it has been found that a solar cell comprising InGaN quantum well layers having varying bandgaps is particularly and unexpectedly advantageous in terms of offering an increased absorption of light within the active layer, a reduced overall strain within the structure and reduced detrimental polarisation effects within p-i-n structures (Ga-faced GaN/InGaN structures) along with improved advantageous polarisation effects in n-i-p structures (Ga-faced GaN/InGaN structures).

Therefore, in one highly preferred embodiment a solar cell comprising:
(a) a first junction layer;
(b) a second junction layer; and
(c) an active region between the first and second junction layers, the active region comprising a plurality of InGaN quantum well layers each of which is sandwiched between barrier layers,
wherein, consecutive quantum well layers have different bandgap values due to variations in their indium and gallium content and the indium content of consecutive quantum well layers increases on moving away from a surface of the solar cell upon which, in use, sunlight will be incident.

The comments made in regard to FIGs 1 and 2 and the embodiments described herein apply, *mutatis mutandis,* to the embodiment.

In a second aspect the invention resides in a method of forming a solar cell comprising a multiple quantum well structure, the method including the steps of:
(a) forming a barrier layer;
(b) forming a desired thickness of a quantum well layer comprising at least one group III nitride on top of the barrier layer;
(c) forming a further barrier layer on top of the exposed quantum well layer such that the quantum well layer is sandwiched between the two barrier layers;
(d) forming a desired thickness of a further quantum well layer comprising at least one group II to VI element on top of the exposed further barrier layer; and
(e) repeating steps (c) to (d) to form a desired number of quantum wells wherein consecutive quantum well layers have different bandgap values due to variations in the thickness of the layers and/or their having differing contents of the at least one group III nitride,
to thereby form a solar cell comprising a multiple quantum well structure.

In one preferred embodiment, the content of the at least one III element in consecutive quantum well layers increases on moving further away from an extent of the solar cell upon which, in use, sunlight is incident.

In one embodiment, the at least one group III element content within individual quantum well layers is substantially constant.

In an alternative embodiment, the at least one group III element content within individual quantum well layers may vary in a continuous fashion on proceeding through the quantum well layer from a region contacting one adjacent barrier layer to a region contacting the other adjacent barrier layer.

The method may further include the step of forming a junction layer on a substrate and subsequently forming the first barrier layer or quantum well layer upon the junction layer.

The method may further include the step of forming a further junction layer on top of the final quantum well layer to be formed.

In an alternative embodiment, the method may include the step of forming the multiple quantum well structure such that the content of the at least one group III element in consecutive quantum well layers decreases on moving further away from an extent of the solar cell upon which, in use, sunlight is incident.

In this alternative embodiment, the method may further include the step of separating the multiple quantum well structure from an underlying substrate and reversing the structure such that the content of the at least one group III element in consecutive quantum well layers increases on moving further away from an extent of the solar cell upon which, in use, sunlight is incident.

The solar cell of this alternative embodiment may be formed on a transparent substrate.

The method may further include the step of forming one or more blocking layers, as described herein.

The solar cells within the scope of the present invention may be formed using a number of standard deposition methods including but not necessarily limited to metal organic chemical vapour deposition (MOCVD), remote plasma chemical vapour deposition (RPCVD) and plasma-assisted molecular beam epitaxy (PAMBE). Key parameters in the control of indium content in successive quantum wells are the growth temperature, which should be lowered for layers with increasing indium content, and the indium flux or flow rate of trimethyl indium reagent and the gallium flux or flow rate of trimethyl gallium reagent.

In a highly preferred embodiment, the quantum well layers comprise InGaN. It may be preferable that the quantum well layer with the lowest indium content is grown first and consecutive quantum well layers are then grown with increasing indium content. This allows the use of higher temperatures for low indium content layers which are less likely to degrade in such temperatures. The use of higher temperatures reduces lattice mismatch and therefore strain in the solar cell.

As will be apparent from the results described herein, such solar cells provide distinct functional advantages over those of the prior art.

It will be appreciated that the various features and embodiments of the present invention, referred to in individual sections above apply, as appropriate, to other sections, *mutatis mutandis.* Consequently features specified in one section may be combined with features specified in other sections, as appropriate.

### EXPERIMENTAL

### PV A

A solar cell (PV A) was grown according to the structure described in Table 1 and represented in FIG 1. Growth of the layers may be carried out in a standard manner using well developed technologies such as MOCVD. Growth conditions are also standard in nature and would be well known to a person of skill in the art.

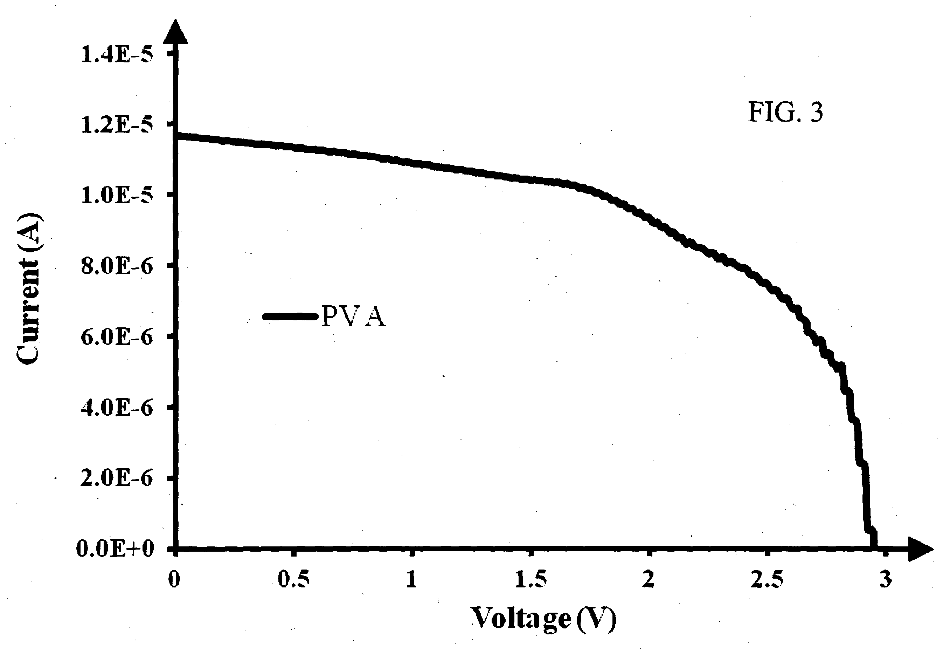

This cell was then tested and shown to have an energy conversion efficiency (η) of about 1.4 %, as is shown in FIG 3. FIG 3 also indicates that under the test conditions the short-circuit current (I_{sc}) is 11.7 µA, the open circuit voltage (V_{oc}) is ∼2.95 V and the fill factor (FF) is -55.6 %. In light of the reported energy conversion efficiency values for conventional InGaN solar cells this represents an improved figure.

A photovoltaic simulation of this structure was also carried out using SCSim software developed by Semiconductor Technology Research Inc. (STR). The simulation results showed the theoretical fill factor (FF) for this structure to be about 72 % which is higher than the FF of about 43 % calculated for an MQW solar cell structure having quantum well layers which each have a fixed indium content of 15 % but otherwise presenting the same cell structure as shown in FIG 1. This indicates that the solar cell 10 represented by FIG 1 having quantum well layers 40 with an indium content which varies from one layer to the next can provide for an increase in the FF and thereby can potentially increase the efficiency of InGaN solar cells.

In a further example, a solar cell similar to that shown in FIG 1 could be synthesised wherein the indium and gallium content of each quantum well layer is constant. The required variation in bandgap could instead be achieved by varying the thickness of consecutively formed quantum well layers. In one non-limiting example where five quantum well layers are contained in the solar cell then the thicknesses of each layer may be 4.5 nm, 4 nm, 3.5 nm, 3 nm, and 2.5 nm in proceeding from the bottom (first formed layer) to the top (sun facing and last formed layer).

The variation in thickness of the quantum well layers may also be employed in combination with variations in the composition to achieve the required bandgap variation.

### PV B

A solar cell (PV B) was grown on a sapphire substrate according to the structure described in Table 2. AlGaN blocking layers were laid down with a *p*-AlGaN layer grown before the *p*-GaN layer and an *n*-AlGaN layer grown after the *n*-GaN layer. A solar cell simulation was carried out for this structure and the results show that the energy conversion efficiency in this varying band gap solar cell structure is 22% improved when compared to a structure in which the indium percentage in the QW layers was constant at an average indium percentage of 17.5% while keeping all the other parameters the same.

### PV C

A solar cell (PV C) was grown on a patterned sapphire substrate according to the structure set out in Table 3. The use of the patterned sapphire substrate was the only structural difference between PV B and PV C.

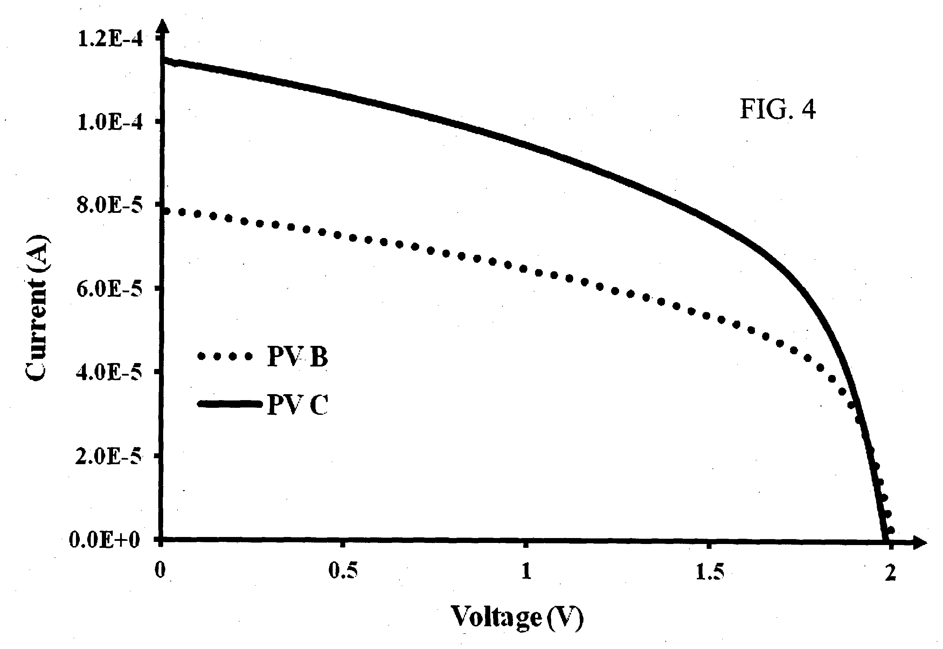

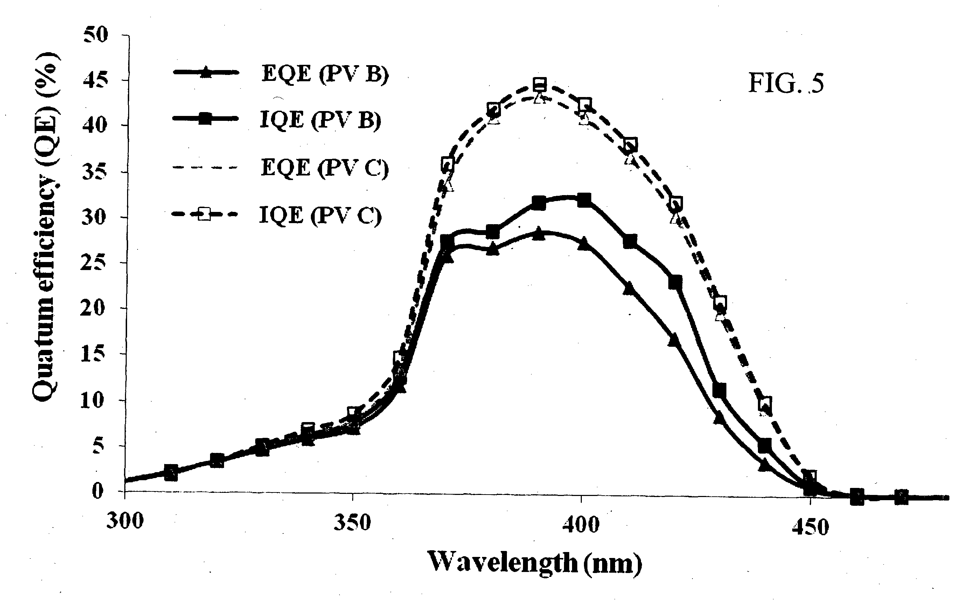

The I-V characteristics of samples PV B and PV C are shown in FIG 4. PV C shows increased short-circuit current density compared to PV B, which indicates that PV C has improved structural qualities. The solar cell efficiency of PV C is ∼1.28 %, considerably better than that of PV B (∼0.9 %) as shown in Table 4. These values compare favourably with existing solar cell designs especially for the indium content employed. The improved quality of PV C over PV B is also evident from external quantum efficiency (EQE) and internal quantum efficiency (IQE) measurement results as shown in FIG 5. The maximum EQE and IQE of PV C are 43.6 % and 44.9 % respectively. In light of the reported quantum efficiency values for conventional InGaN solar cells, these represent improved figures. These EQE and IQE values are also higher than those of PV B which had a maximum EQE and IQE of 28.7 % and 31.9 %, respectively.

Although not wishing to be bound by any particular theory, it is believed that the effect demonstrated experimentally, above, may be due, at least in part, to improved absorption across the solar spectrum and thereby the higher generation of electron-hole pairs as well as a reduced incidence of polarization-related issues due to the particular solar cell design.

Throughout the specification the aim has been to describe the preferred embodiments of the invention without limiting the invention to any one embodiment or specific collection of features. It will therefore be appreciated by those of skill in the art that, in light of the instant disclosure, various modifications and changes can be made in the particular embodiments exemplified without departing from the scope of the present invention.

### TABLES

**Table 1: One embodiment of an MQW solar cell structure showing differing indium content between individual QW layers. Certain other layers and dopant concentrations (per cc) are also shown.**

| **N** | **Name** | **Thickness (nm)** | **Material** | **Doping** |
|---|---|---|---|---|
| 32 | p-GaN | 150 | GaN | Na = 1e18 |
| 31 | i-InGaN | 3 | In _{0.01} Ga _{0.99} N | Nd = 5e16 |
| 30 | GaN | 12 | GaN | Nd = 5e16 |
| 29 | i-InGaN | 3 | In _{0.02} Ga _{0.98} N | Nd = 5e16 |
| 28 | GaN | 12 | GaN | Nd = 5e16 |
| 27 | i-InGaN | 3 | In _{0.03} Ga _{0.97} N | Nd = 5e16 |
| 26 | GaN | 12 | GaN | Nd = 5e16 |
| 25 | i-InGaN | 3 | In _{0.04}Ga_{0.96} N | Nd = 5e16 |
| 24 | GaN | 12 | GaN | Nd = 5e16 |
| 23 | i-InGaN | 3 | In _{0.05} Ga _{0.95} N | Nd = 5e16 |
| 22 | GaN | 12 | GaN | Nd = 5e16 |
| 21 | i-InGaN | 3 | In _{0.06}Ga_{0.94} N | Nd = 5e16 |
| 20 | GaN | 12 | GaN | Nd = 5e16 |
| 19 | i-InGaN | 3 | In _{0.07} Ga _{0.93} N | Nd = 5e16 |
| 18 | GaN | 12 | GaN | Nd = 5e16 |
| 17 | i-InGaN | 3 | In _{0.08}Ga_{0.92} N | Nd = 5e16 |
| 16 | GaN | 12 | GaN | Nd = 5e16 |
| 15 | i-InGaN | 3 | In _{0.09} Ga _{0.91} N | Nd = 5e16 |
| 14 | GaN | 12 | GaN | Nd = 5e16 |
| 13 | i-InGaN | 3 | In _{0.10} Ga _{0.90} N | Nd = 5e16 |
| 12 | GaN | 12 | GaN | Nd = 5e16 |
| 11 | i-InGaN | 3 | In _{0.11} Ga _{0.89} N | Nd = 5e16 |
| 10 | GaN | 12 | GaN | Nd = 5e16 |
| 9 | i-InGaN | 3 | In _{0.12} Ga _{0.88} N | Nd = 5e16 |
| 8 | GaN | 12 | GaN | Nd = 5e16 |
| 7 | i-InGaN | 3 | In _{0.13} Ga_{0.87} N | Nd = 5e16 |
| 6 | GaN | 12 | GaN | Nd = 5e16 |
| 5 | i-InGaN | 3 | In _{0.14}Ga_{0.86} N | Nd = 5e16 |
| 4 | GaN | 12 | GaN | Nd = 5e16 |
| 3 | i-InGaN | 3 | In _{0.15} Ga_{0.85} N | Nd = 5e16 |
| 2 | GaN | 12 | GaN | Nd = 5e16 |
| 1 | n-GaN | 2000 | GaN | Nd = 1e19 |

**Table 2: An MQW solar cell structure grown on a sapphire substrate showing differing indium content between individual QW layers and comprising AlGaN/GaN blocking layers.**

| **N** | **Name** | **Thickness (nm)** | **Material** |
|---|---|---|---|
| 46 | p-GaN | 178 | GaN |
| 45 | p-AlGaN | 1.19 | Al _{0.15} Ga_{0.85} N |
| 44 | p-GaN | 2.02 | GaN |
| 43 | i-InGaN | 2.55 | In _{0.20} Ga_{0.80} N |
| 42 | GaN | 6.50 | GaN |
| 41 | i-InGaN | 2.55 | In _{0.1974} Ga_{0.8026} N |
| 40 | GaN | 6.50 | GaN |
| 39 | i-InGaN | 2.55 | In _{0.1947} Ga _{0.8053} N |
| 38 | GaN | 6.50 | GaN |
| 37 | i-InGaN | 2.55 | In _{0.1921} Ga_{0.8079} N |
| 36 | GaN | 6.50 | GaN |
| 35 | i-InGaN | 2.55 | In _{0.1895} Ga _{0.8105} N |
| 34 | GaN | 6.50 | GaN |
| 33 | i-InGaN | 2.55 | In _{0.1868}Ga _{0.8132} N |
| 32 | GaN | 6.50 | GaN |
| 31 | i-InGaN | 2.55 | In _{0.1842} Ga _{0.8158} N |
| 30 | GaN | 6.50 | GaN |
| 29 | i-InGaN | 2.55 | In _{0.1816} Ga _{0.8184} N |
| 28 | GaN | 6.50 | GaN |
| 27 | i-InGaN | 2.55 | In _{0.1789} Ga _{0.8211}N |
| 26 | GaN | 6.50 | GaN |
| 25 | i-InGaN | 2.55 | In _{0.1763} Ga_{0.8237} N |
| 24 | GaN | 6.50 | GaN |
| 23 | i-InGaN | 2.55 | In _{0.1737} Ga _{0.8263} N |
| 22 | GaN | 6.50 | GaN |
| 21 | i-InGaN | 2.55 | In _{0.1710} Ga_{0.8290} N |
| 20 | GaN | 6.50 | GaN |
| 19 | i-InGaN | 2.55 | In _{0.1684}Ga_{0.8316} N |
| 18 | GaN | 6.50 | GaN |
| 17 | i-InGaN | 2.55 | In _{0.1658} Ga _{0.8342} N |
| 16 | GaN | 6.50 | GaN |
| 15 | i-InGaN | 2.55 | In _{0.1632} Ga _{0.8368} N |
| 14 | GaN | 6.50 | GaN |
| 13 | i-InGaN | 2.55 | In _{0.1605} Ga _{0.8395} N |
| 12 | GaN | 6.50 | GaN |
| 11 | i-InGaN | 2.55 | In _{0.1579} Ga _{0.8421} N |
| 10 | GaN | 6.50 | GaN |
| 9 | i-InGaN | 2.55 | In _{0.1553} Ga _{0.8447} N |
| 8 | GaN | 6.50 | GaN |
| 7 | i-InGaN | 2.55 | In _{0.1526}Ga _{0.8474} N |
| 6 | GaN | 6.50 | GaN |
| 5 | i-InGaN | 2.55 | In _{0.15} Ga_{0.85} N |
| 4 | GaN | 6.50 | GaN |
| 3 | n-AlGaN | 1.19 | Al _{0.15} Ga_{0.85} N |
| 2 | n-GaN | 2.02 | GaN |
| 1 | n-GaN | 200 | GaN |
| Buffer GaN (∼3 µm) | | | |
| Sapphire substrate | | | |

**Table 3: An MQW solar cell structure grown on a patterned sapphire substrate (PSS) showing differing indium content between individual QW layers and comprising AlGaN/GaN blocking layers.**

| **N** | **Name** | **Thickness (nm)** | **Material** |
|---|---|---|---|
| 46 | p-GaN | 178 | GaN |
| 45 | p-AlGaN | 1.19 | Al _{0.15} Ga_{0.85} N |
| 44 | p-GaN | 2.02 | GaN |
| 43 | i-InGaN | 2.55 | In _{0.20} Ga_{0.80} N |
| 42 | GaN | 6.50 | GaN |
| 41 | i-InGaN | 2.55 | In _{0.1974} Ga_{0.8026} N |
| 40 | GaN | 6.50 | GaN |
| 39 | i-InGaN | 2.55 | In _{0.1947} Ga _{0.8053} N |
| 38 | GaN | 6.50 | GaN |
| 37 | i-InGaN | 2.55 | In _{0.1921} Ga_{0.8079} N |
| 36 | GaN | 6.50 | GaN |
| 35 | i-InGaN | 2.55 | In _{0.1895} Ga _{0.8105} N |
| 34 | GaN | 6.50 | GaN |
| 33 | i-InGaN | 2.55 | In _{0.1868}Ga _{0.8132} N |
| 32 | GaN | 6.50 | GaN |
| 31 | i-InGaN | 2.55 | In _{0.1842} Ga _{0.8158} N |
| 30 | GaN | 6.50 | GaN |
| 29 | i-InGaN | 2.55 | In _{0.1816} Ga _{0.8184} N |
| 28 | GaN | 6.50 | GaN |
| 27 | i-InGaN | 2.55 | In _{0.1789} Ga _{0.8211}N |
| 26 | GaN | 6.50 | GaN |
| 25 | i-InGaN | 2.55 | In _{0.1763} Ga_{0.8237} N |
| 24 | GaN | 6.50 | GaN |
| 23 | i-InGaN | 2.55 | In _{0.1737} Ga _{0.8263} N |
| 22 | GaN | 6.50 | GaN |
| 21 | i-InGaN | 2.55 | In _{0.1710} Ga_{0.8290} N |
| 20 | GaN | 6.50 | GaN |
| 19 | i-InGaN | 2.55 | In _{0.1684}Ga_{0.8316} N |
| 18 | GaN | 6.50 | GaN |
| 17 | i-InGaN | 2.55 | In _{0.1658} Ga _{0.8342} N |
| 16 | GaN | 6.50 | GaN |
| 15 | i-InGaN | 2.55 | In _{0.1632} Ga _{0.8368} N |
| 14 | GaN | 6.50 | GaN |
| 13 | i-InGaN | 2.55 | In _{0.1605} Ga _{0.8395} N |
| 12 | GaN | 6.50 | GaN |
| 11 | i-InGaN | 2.55 | In _{0.1579} Ga _{0.8421} N |
| 10 | GaN | 6.50 | GaN |
| 9 | i-InGaN | 2.55 | In _{0.1553} Ga _{0.8447} N |
| 8 | GaN | 6.50 | GaN |
| 7 | i-InGaN | 2.55 | In _{0.1526}Ga_{0.8474} N |
| 6 | GaN | 6.50 | GaN |
| 5 | i-InGaN | 2.55 | In _{0.15} Ga_{0.85} N |
| 4 | GaN | 6.50 | GaN |
| 3 | n-AlGaN | 1.19 | Al _{0.15} Ga_{0.85} N |
| 2 | n-GaN | 2.02 | GaN |
| 1 | n-GaN | 200 | GaN |
| Buffer GaN (∼3 µm) | | | |
| Patterned sapphire substrate (PSS) | | | |

**Table 4: Characteristics and solar cell efficiency of PV B and PV C.**

| Sample | Substrate type | I_{sc} (mA) | J_{sc} (mA/cm²) | V_{oc} (V) | FF (%) | η (%) |
|---|---|---|---|---|---|---|
| PV B | Sapphire | 0.0789 | 0.877 | 2.0039 | 51.8 | 0.9103 |
| PV C | PSS | 0.1147 | 1.275 | 1.9825 | 50.6 | 1.2791 |

**Table 5: External (EQE) and internal (IQE) quantum efficiency of PV B and PV C.**

| Sample | Substrate type | Max EQE (%) | Corresponding wavelength (nm) | Max IQE (%) | Corresponding wavelength (nm) |
|---|---|---|---|---|---|
| PV B | Sapphire | 28.7 | 390 | 31.9 | 390 |
| PV C | PSS | 43.6 | 390 | 44.9 | 400 |

## Claims

1. A solar cell comprising:
(a) a first junction layer (20);
(b) a second junction layer (50); and
(c) an active region between the first and second junction layers (20,50), the active region comprising a plurality of quantum well layers (40) each of which is sandwiched between barrier layers (30) and the material forming each quantum well layer (40) is independently a group III nitride,
**characterised in that** consecutive quantum well layers (40) have different bandgap values due to variations in the thickness of the layers and/or their having differing compositions of at least one of their constituent elements and wherein each quantum well layer (40) is less than 7 nm thick.

2. The solar cell of claim 1 wherein the bandgap of consecutive quantum well layers (40) decreases on moving away from a surface of the solar cell upon which, in use, sunlight will be incident.

3. The solar cell of claim 1 wherein the constituent elements are selected from the group consisting of aluminium, gallium, indium and nitrogen.

4. The solar cell of claim 1 wherein the content of at least one of the constituent elements in consecutive quantum well layers (40) increases on moving further away from an extent of the solar cell upon which, in use, sunlight is incident and/or the thickness of consecutive quantum well layers (40) decreases on moving further away from an extent of the solar cell upon which, in use, sunlight is incident.

5. The solar cell of claim 1 wherein the composition of individual quantum well layers (40) is substantially constant throughout their extent.

6. The solar cell of claim 1 wherein the composition of individual quantum well layers (40) varies in a continuous fashion on proceeding through the quantum well layer (40) from a region contacting one adjacent barrier layer (30) to a region contacting the next adjacent barrier layer (30), preferably it is the relative content of at least two group III elements selected from the group consisting of indium, aluminium and gallium which varies.

7. The solar cell of claim 1 wherein the material forming the quantum well layers (40) is selected from the group consisting of indium gallium nitride, aluminium indium gallium nitride, indium aluminium nitride, and aluminium gallium nitride, .

8. The solar cell of claim 1 wherein the quantum well layers (40) comprise indium gallium nitride and the indium and gallium contents vary between consecutive quantum well layers (40), preferably the quantum well layer (40) having the highest bandgap and being located at the end of the solar cell closest to the surface adapted to receive sunlight will be the quantum well layer (40) with the lowest indium content.

9. The solar cell of claim 1 wherein the barrier layers (30) comprise material selected from the group consisting of gallium nitride, aluminium nitride, indium gallium nitride, indium aluminium nitride and aluminium indium gallium nitride and preferably the barrier layers (30) are selected such that the bandgaps of the barrier layers (30) are higher than the bandgap of the sandwiched quantum well layer (40).

10. The solar cell of claim 1 wherein the solar cell further comprises one or more blocking layers, preferably aluminium gallium nitride blocking layers, and wherein the cell is a p-i-n structure and is grown to have at least one blocking layer present before the p-layer and after the n-layer.

11. The solar cell of claim 1 wherein the junction layer (20, 30) closest to the sunlit surface has a higher bandgap than the subsequent quantum well or barrier layers (40, 30) and wherein the first and second junction layers (20, 50) independently comprise gallium nitride, indium gallium nitride or indium aluminium gallium nitride.

12. A method of forming a solar cell comprising a multiple quantum well structure, the method including the steps of:
(a) forming a barrier layer (30);
(b) forming a desired thickness of a quantum well layer (40) from a group III nitride on top of the barrier layer (30);
(c) forming a further barrier layer (30) on top of the exposed quantum well layer (40) such that the quantum well layer (40) is sandwiched between the two barrier layers (30);
(d) forming a desired thickness of a further quantum well layer (40) from a group III nitride on top of the exposed further barrier layer (30); and
(e) repeating steps (c) to (d) to form a desired number of quantum wells, **characterised in that** consecutive quantum well layers (40) have different bandgap values due to variations in the thickness of the layers and/or their having differing contents of the at least one group III nitride,
and wherein each quantum well layer (40) is less than 7 nm thick, to thereby form a solar cell comprising a multiple quantum well structure.

13. The method of claim 12 wherein the quantum well layers (40) are indium gallium nitride layers and the indium and gallium content vary in consecutive layers.

14. The method of claim 12 including the step of increasing the content of the at least one group III nitride in consecutive quantum well layers (40) on moving further away from an extent of the solar cell upon which, in use, sunlight is incident.

15. The method of claim 13 including the step of growing the quantum well layers (40) having the lowest indium content before those having higher indium contents.

## Patentansprüche

1. Solarzelle aufweisend:
(a) eine erste Verbindungsschicht (20);
(b) eine zweite Verbindungsschicht (50); und
(c) einen aktiven Bereich zwischen der ersten und der zweiten Verbindungsschicht (20, 50) wobei der aktive Bereich eine Vielzahl von Quantentopfschichten aufweist, wobei jede davon zwischen Sperrschichten (30) angeordnet ist wobei das Material welches jeden Quantentopf (40) ausbildet unabhängig ein Gruppe-III-Nitrid ist,
**dadurch gekennzeichnet,**
**dass** aufeinanderfolgende Quantentopfschichten (40) unterschiedliche Bandlückenwerte aufgrund von Variationen in der Dicke der Schichten und/oder ihrer unterschiedlichen Zusammensetzung von mindestens einem ihrer Bestandteile aufweisen und wobei jede Quantentopfschicht (40) weniger als 7 nm dick ist.

2. Solarzelle nach Anspruch 1,
wobei die Bandlücke aufeinanderfolgender Quantentopfschichten (40) abnimmt, wenn man sich von einer Oberfläche der Solarzelle, auf die im Gebrauch Sonnenlicht einfällt, wegbewegt.

3. Solarzelle nach Anspruch 1,
wobei die Bestandteile aus einer Gruppe ausgewählt werden welche aufweist, Aluminium, Gallium, Indium und Stickstoff.

4. Solarzelle nach Anspruch 1,
wobei der Gehalt von mindestens einem der Bestandteile in aufeinanderfolgenden Quantentopfschichten (40) zunimmt, wenn man sich weiter weg von einem Bereich der Solarzelle entfernt, auf die im Gebrauch Sonnenlicht einfällt und/oder die Dicke von aufeinanderfolgenden Quantentopfschichten (40) abnimmt wenn man sich weiter weg von einem Bereich der Solarzelle entfernt auf den bei Verwendung Sonnenlicht einfällt.

5. Solarzelle nach Anspruch 1,
wobei die Zusammensetzung von individuellen Quantentopfschichten (40) im Wesentlichen konstant über ihre gesamte Ausdehnung ist.

6. Solarzelle nach Anspruch 1,
wobei die Zusammensetzung von individuellen Quantentopflagen (40) bei Durchgang durch die Quantentopfschicht (40) von einem Bereich, der eine benachbarte Sperrschicht berührt zu einem Bereich der die nächste benachbarte Sperrschicht berührt kontinuierlich variiert, bevorzugt ist der relative Gehalt von mindestens zwei Elementen der Gruppe III ausgewählt aus der Gruppe aufweisend Indium, Aluminium und Gallium der variiert.

7. Solarzelle nach Anspruch 1,
wobei das Material das die Quantentopfschichten (40) ausbildet aus einer Gruppe ausgewählt ist welche aufweist Indium, Gallium-Nitrid, Aluminium-Indium-Galliumnitrid, Indium-Aluminium-Nitrid und Aluminium-Gallium-Nitrid.

8. Solarzelle nach Anspruch 1,
wobei die Quantentopfschichten (40) Indium-Gallium-Nitrid aufweisen und der Indium- und Galliumgehalt zwischen benachbarten Quantentopflagen (40) variiert, wobei bevorzugt die Quantentopfschicht (40) mit der höchsten Bandlücke die sich am Ende der Solarzelle am nächsten an der Oberfläche befindet die für den Empfang von Sonnenlicht geeignet ist, die Quantentopfschicht (40) mit dem geringsten Indiumgehalt ist.

9. Solarzelle nach Anspruch 1,
wobei die Sperrschichten (30) ein Material aufweisen ausgewählt aus einer Gruppe aufweisend Galliumnitrid, Aluminiumnitrid, Indium-Gallium-Nitrid, Indium-Aluminium-Nitrid und Aluminium-Indium-Gallium-Nitrid und bevorzugt sind die Sperrschichten (30) ausgewählt so dass die Bandlücken der Sperrschichten (30) höher ist als die Bandlücke von zwischen angeordneten Quantentopfschichten (40).

10. Solarzelle nach Anspruch 1,
wobei die Solarzelle des Weiteren aufweist eine oder mehrere sperrende Schichten, bevorzugt Aluminium-Gallium-Nitrid-sperrende Schichten und wobei die Zelle eine P-I-N-Struktur ist und gezüchtet wird dass vor der P-Schicht und nach der N-Schicht mindestens eine Sperrschicht vorhanden ist.

11. Solarzelle nach Anspruch 1,
wobei die Verbindungsschicht (20, 30) welche am nächsten zu der sonnenbeschienen Oberfläche ist eine höhere Bandlücke aufweist als die nachfolgende Quantentopf- oder Sperrschicht (40, 30) und wobei die erste und die zweite Verbindungsschicht (20, 50) unabhängig aufweisen Gallium-Nitrid, Indium-Gallium-Nitrid oder Indium-Aluminium-Gallium-Nitrid.

12. Verfahren zum Ausbilden einer Solarzelle aufweisend eine Mehrfach-Quantentopfstruktur, wobei das Verfahren die Schritte aufweist:
(a) Ausbilden einer Sperrschicht (30);
(b) Ausbilden einer gewünschten Dicke einer Quantentopfschicht aus einem Gruppe-III-Nitrid auf der Sperrschicht (30),
(c) Ausbilden einer weiteren Sperrschicht (30) auf der exponierten Quantentopfschicht (40) so dass die Quantentopfschicht (40) zwischen den beiden Sperrschichten (30) liegt,
(d) Ausbilden einer gewünschten Dicke einer weiteren Quantentopfschicht (40) aus einem Gruppe-III-Nitrid auf der exponierten weiteren Sperrschicht (30); und
(e) Widerholen der Schritte (c) bis (d) um eine gewünschte Anzahl von Quantentöpfen auszubilden,
**dadurch gekennzeichnet,**
**dass** aufeinanderfolgende Quantentopfschichten (40) unterschiedliche Bandlückenwerte aufgrund von Variationen in der Dicke der Lagen und/oder ihres unterschiedlichen Gehaltes des mindestens einen Gruppe-III-Nitrids haben, und wobei jede Quantentopfschicht (40) weniger als 4 nm dick ist um dabei eine Solarzelle auszubilden welche eine Mehrfach-Quantentopfstruktur hat.

13. Verfahren nach Anspruch 12,
wobei die Quantentopfschichten (40) Indium-Gallium-Nitrid-Schichten sind und der Indium- und Galliumgehalt in benachbarten Schichten variiert.

14. Verfahren nach Anspruch 12,
aufweisend den Schritt des Erhöhens des Gehaltes des mindestens einen Gruppe-III-Nitrids in benachbarten Quantentopfschichten (40) beim Entfernen von einer Ausdehnung der Solarzelle auf die im Gebrauch Sonnenlicht einfällt.

15. Verfahren nach Anspruch 13,
aufweisend den Schritt des Wachsen der Quantentopfschichten (40) mit dem geringsten Indium-Gehalt vor den mit einem höheren Indium-Gehalt.

## Revendications

1. Cellule solaire, comprenant :
(a) une première couche (20) de jonction ;
(b) une deuxième couche (50) de jonction ; et
(c) une région active entre la première et la deuxième couches (20, 50) de jonction, la région active comprenant une pluralité de couches (40) de puits quantique, chacun d'eux étant pris en sandwich entre des couches (30) formant barrière et le matériau formant chaque couche (40) de puits quantique est, indépendamment, un nitrure du groupe III,
**caractérisée en ce que** des couches (40) consécutives de puits quantique ont des valeurs différentes de bande interdite dues à des variations de l'épaisseur des couches et/ou **en ce qu'**elles ont des compositions différentes d'au moins l'un de leurs éléments constitutifs et dans laquelle chaque couche (40) de puits quantique a une épaisseur de moins de 7 nm.

2. Cellule solaire suivant la revendication 1, dans laquelle la bande interdite de couches (40) consécutives de puits quantique diminue au fur et à mesure que l'on s'éloigne d'une surface de la cellule solaire sur laquelle, en utilisation, de la lumière solaire sera incidente.

3. Cellule solaire suivant la revendication 1, dans laquelle les éléments constitutifs sont choisis dans le groupe consistant en l'aluminium, le gallium, l'indium et l'azote.

4. Cellule solaire suivant la revendication 1, dans laquelle la teneur en au moins l'un des éléments constitutifs de couches (40) consécutives de puits quantique augmente au fur et à mesure que l'on s'éloigne d'une étendue de la cellule solaire sur laquelle, en utilisation, de la lumière solaire est incidente et/ou l'épaisseur de couches (40) consécutives de puits quantique diminue au fur et à mesure que l'on s'éloigne d'une étendue de la cellule solaire sur laquelle, en utilisation, de la lumière solaire est incidente.

5. Cellule solaire suivant la revendication 1, dans laquelle la composition de couches (40) individuelles de puits quantique est sensiblement constante sur toute leur étendue.

6. Cellule solaire suivant la revendication 1, dans laquelle la composition de couches (40) individuelles de puits quantique varie d'une façon continue dans la couche (40) de puits quantique d'une région en contact avec une couche (30) voisine formant barrière à une région en contact avec la couche (30) voisine suivante formant barrière, de préférence c'est la teneur relative d'au moins deux éléments du groupe III, choisis dans le groupe consistant en l'indium, l'aluminium et le gallium, qui varie.

7. Cellule solaire suivant la revendication 1, dans laquelle le matériau formant les couches (40) de puits quantique est choisi dans le groupe consistant en le nitrure d'indium et de gallium, le nitrure d'aluminium, d'indium et de gallium, le nitrure d'indium et d'aluminium et le nitrure d'aluminium et de gallium.

8. Cellule solaire suivant la revendication 1, dans laquelle les couches (40) de puits quantique comprennent du nitrure d'indium et de gallium et les teneurs en indium et en gallium varient entre des couches (40) consécutives de puits quantique, de préférence la couche (40) de puits quantique, ayant la bande interdite la plus haute et étant disposée à l'extrémité de la cellule solaire la plus proche de la surface conçue pour recevoir de la lumière solaire, sera la couche (40) de puits quantique ayant la teneur en indium la plus petite.

9. Cellule solaire suivant la revendication 1, dans laquelle les couches (30) formant barrière comprennent du matériau choisi dans le groupe consistant en le nitrure de gallium, le nitrure d'aluminium, le nitrure d'indium et de gallium, le nitrure d'indium et d'aluminium et le nitrure d'aluminium, d'indium et de gallium et, de préférence, les couches (30) formant barrière sont choisies de manière à ce que les bandes interdites des couches (30) formant barrière soient plus hautes que la bande interdite de la couche (40) de puits quantique prise en sandwich.

10. Cellule solaire suivant la revendication 1, dans laquelle la cellule solaire comprend, en outre, une ou plusieurs couches de blocage, de préférence des couches de blocage en nitrure d'aluminium et de gallium, et dans laquelle la cellule est une structure p-i-n et a subi une croissance pour avoir au moins une couche de blocage présente avant la couche p et après la couche n.

11. Cellule solaire suivant la revendication 1, dans laquelle la couche (20, 30) de jonction la plus proche de la surface éclairée par le soleil a une bande interdite plus haute que les couches (40, 30) de puits quantique ou formant barrière subséquentes et dans laquelle la première et la deuxième couches (20, 50) de jonction comprennent, indépendamment, du nitrure de gallium, du nitrure d'indium et de gallium ou du nitrure d'indium, d'aluminium et de gallium.

12. Procédé de formation d'une cellule solaire, comprenant une structure multiple de puits quantique, le procédé comprenant les stades dans lesquels :
(a) on forme une couche (30) formant barrière ;
(b) on forme une épaisseur souhaitée d'une couche (40) de puits quantique en un nitrure du groupe III au dessus de la couche (30) formant barrière ;
(c) on forme une autre couche (30) formant barrière au-dessus de la couche (40) de puits quantique à découvert, da manière à prendre en sandwich la couche (40) de puits quantique entre les deux couches (30) formant barrière ;
(d) on forme une épaisseur souhaitée d'une autre couche (40) de puits quantique, en un nitrure du groupe III au-dessus de l'autre couche (30) formant barrière à découvert ; et
(e) on répète les stades (c) à (d) pour former un nombre souhaité de puits quantiques, **caractérisé en ce que** les couches (40) consécutives de puits quantique ont des valeurs différentes de bande interdite dues à des variations de l'épaisseur des couches et/ou **en ce qu'**elles ont des teneurs différentes en le au moins un nitrure du groupe III,
et dans lequel chaque couche (40) de puits quantique a une épaisseur de moins de 7 nm, pour former ainsi une cellule solaire comprenant une structure multiple de puits quantique.

13. Procédé suivant la revendication 12, dans lequel les couches (40) de puits quantique sont des couches en nitrure d'indium et de gallium et la teneur en indium et en gallium varie dans des couches consécutives.

14. Procédé suivant la revendication 12, comprenant le stade d'augmentation de la teneur du au moins un nitrure du groupe III dans des couches (40) consécutives de puits quantique, au fur et à mesure que l'on s'éloigne d'une étendue de la cellule solaire sur laquelle, en utilisation, de la lumière solaire est incidente.

15. Procédé suivant la revendication 13, comprenant le stade de croissance des couches (40) de puits quantique ayant la teneur en indium la plus petite avant celles ayant des teneurs en indium plus grandes.
